# EUROPEAN PATENT SPECIFICATION

(11) **EP 0 803 542 B1**
(45) Date of publication and mention of the grant of the patent: **18.09.2002**
(21) Application number: 97302790.7
(22) Date of filing: 24.04.1997
(51) Int. Cl.: C08L 83/07, C09J 183/07, C08K 3/08, C08J 3/24

(54) **Electrically conductive silicone elastomer compositions and use for manufacturing semiconductor devices**
Elektrisch leitfähige Silikonkautschukzusammensetzung und ihre Anwendung zur Herstellung von Halbleiteranordnungen
Composition électroconductive de caoutchouc de silicone et leur emploi dans la fabrication de dispositifs semi-conducteurs

(30) Priority: 26.04.1996 JP 13143596
(43) Date of publication of application: 29.10.1997
(73) Proprietor: Dow Corning Toray Silicone Company Ltd., Ichihara-shi, Chiba Prefecture (JP)
(72) Inventor: Mine, Katsutoshi, Dow Corning Toray Silicone, Ichihara-shi, Chiba Prefecture (JP); Mitani, Osamu, Dow Corning Toray Silicone, Ichihara-shi, Chiba Prefecture (JP); Nakayoshi Kazumi, Dow Corning Toray Silicone, Ichihara-shi, Chiba Prefecture (JP); Tazawa, Rikako, Dow Corning Toray Silicone, Ichihara-shi, Chiba Prefecture (JP)
(74) Representative: Kyle, Diana

(56) References cited:
- EP-A- 0 238 033
- EP-A- 0 373 659
- EP-A- 0 653 463
- WO-A-92/10543

## Description

The present invention relates to electrically conductive silicone elastomer compositions, methods for manufacturing semiconductor devices, and semiconductor devices More specifically, the present invention relates to electrically conductive silicone elastomer compositions which are curable to form silicone elastomers having outstanding electrical conductivity. When the electrically conductive silicone elastomer composition is applied to a substrate and the periphery of the composition is cured, the composition will not contaminate the substrate, nor the environment in the proximity of the substrate, with low molecular-weight silicone species prior to complete cure of the composition via a hydrosilylation reaction.

The present invention also more specifically relates to methods of manufacturing semiconductor devices using the electrically conductive silicone elastomer compositions of the present invention whereby said composition is used to adhere a semiconductor chip to a substrate, whereby the wire bondability of the semiconductor device is not adversely affected and adhesion defects between the sealing resin and the semiconductor chip, substrate, package, or lead frame are minimized. The present invention also relates to semiconductor devices manufactured by this method which have outstanding reliability.

Electrically conductive silicone elastomer compositions, which are curable to form silicone elastomers, are used as adhesives for adhering quartz oscillators to crystal resonators, to crystal components of crystal filters, and to piezoelectric substrates on packages; or as shielding agents for electromagnetic wave shielding and die bonding agents.

When conventional electrically conductive silicone elastomer compositions are used for these purposes, there are problems with wire bondability (i.e., bonding properties of the bonding wire) to the semiconductor chip or lead frame and defects in adhesion which cause a deterioration in the moisture resistance of the semiconductor device.

To solve these problems, an electrically conductive silicone elastomer composition has been proposed in which the amount of volatile, low molecular-weight siloxane is reduced and curing is carried out by a hydrosilylation reaction (Japanese Patent Application 3-170581). But, even in the case of that electrically conductive composition, the decrease in wire bondability and the adhesion defects are not sufficiently inhibited. Moreover, the moisture resistance of the semiconductor device is not sufficiently improved.

By various studies, we confirmed that when an electrically conductive silicone elastomer composition, curable by hydrosilylation, is used to adhere a semiconductor chip to a substrate, low molecular-weight silicone species outgas from said composition before and during cure. Thus, low molecular-weight species contaminate the surface of the substrate, cause a decrease in wire bondability and adhesion defects. The low molecular-weight silicone species has been determined by us to be a cyclic siloxane contained in the organopolysiloxane of previous electrically conductive silicone elastomer compositions, that is present for curing said composition for improving adhesion of said composition, or for otherwise formulating said composition.

For this reason, we prepared an electrically conductive silicone elastomer composition, cured the composition at room temperature via a hydrosilylation reaction, and attempted to inhibit outgassing of low molecular-weight silicone oil from said composition before and during curing. The handling and workability of this prototype composition were extremely poor.

Moreover, we also attempted to prevent outgassing by mixing an electrically conductive filler with an acrylic modified silicone elastomer composition that was curable via a free radical reaction induced by high energy irradiation. The acrylic modified composition, however, did not sufficiently cure because the high-energy beam was unable to sufficiently penetrate to the inner portion of said composition because of the presence of electrically conductive filler. The portion of the composition in which the high energy beam did not penetrate was defective and uncured.

Therefore, we conducted studies on these problems and found that our claimed compositions possessed decreased outgassing of low molecular-weight silicon-species. Surprisingly, such outgassing is minimized by the use of an acrylic functional group-containing organopolysiloxane that participates in a free radical reaction induced by a high-energy beam, and by the use of siloxane components that are curable via a hydrosilyation reaction.

The composition of this invention is used to adhere a semiconductor chip to a substrate. If the composite is irradiated with high energy radiation, the exposed surfaces of the composition will cure. Once the exposed surfaces are cured, the problem of low molecular-weight silicone species contamination is minimized or eliminated. The composition is then allowed to cure via a hydrosilyation reaction to form a silicone elastomer having outstanding electrical conductivity.

We also discovered that after a semiconductor chip is mounted on a substrate or package using the composition of the present invention, and the resulting composite is irradiated with high-energy radiation, a free radical reaction involving our acrylic functional group-containing organopolysiloxane occurs on the surfaces of the composition that are exposed to high-energy radiation. As a result, outgassing of low-molecular-weight silicone species from our composition is sufficiently inhibited; so the composition may be allowed to fully cure via a hydrosilylation reaction.

The purpose of the present invention is to provide an electrically conductive silicone elastomer composition, which forms a cured silicone elastomer having outstanding electrical conductivity, wherein the periphery of said composition is cured via irradiation with a high-energy beam such that contamination by outgassing low molecular-weight silicone oil, before or during cure is averted. A method for manufacturing a semiconductor device is also provided using this composition which enhances wire bondability to the substrate and reduces adhesion defects between the components of said device and the sealing resin. Consequently, a semiconductor device is manufactured by our method which also has outstanding moisture resistance.

EP-A-0 653 463 discloses an electrically conductive silicone rubber composition curable by hydrosilylation. EP-A-0 238 033 discloses a combination of photocrosslinking with hydrosilylation curing. WO92/10543 discloses the use of acrylic groups in siloxane compositions. EP-A-0 373 659 discloses the use of alkenyl siloxane groups for hydrosilylation curing and acrylic groups for photocrosslinking.

The present invention provides an electrically conductive silicone elastomer composition, comprising
(A) 100 parts by weight of an alkenyl group-containing organopolysiloxane having an average of at least two silicon-bonded alkenyl groups per molecule;
(B) a silicon-bonded hydrogen atom-containing organopolysiloxane having an average of at least two silicon-bonded hydrogen atoms per molecule and an average of at least two silicon-bonded acrylic groups per molecule having the formula 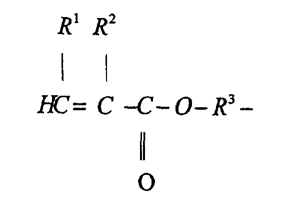 wherein R¹ and R² are each a hydrogen atom or a monovalent hydrocarbon group, and R³ is a divalent hydrocarbon group having 1-10 carbon atoms;
   in an amount sufficient to provide 0.5-20 moles of silicon-bonded hydrogen atoms in component (B) per mole of silicon-bonded alkenyl group in component (A);
(C) 50-2,000 parts by weight of an electrically conductive filler;
(D) 0.1-20 parts by weight of a photosensitizer; and
(E) a platinum-type catalyst, in an amount sufficient to cure the electrically conductive silicone elastomer composition.

The present invention also provides a method for manufacturing a semiconductor device, said method comprising the steps of
mounting a semiconductor chip on a substrate using the electrically conductive silicone silicone elastomer composition of the present invention;
irradiating the composition with a high-energy beam to induce a free radical reaction; and then
curing the composition via a hydrosilylation reaction.

The present invention also relates to a semiconductor device so manufactured.
Component (A) is the main ingredient of the electrically conductive silicone elastomer composition. It is a silicon-bonded alkenyl group-containing organopolysiloxane having an average of at least two alkenyl groups per molecule.

If component (A) contains an average of less than two silicon-bonded alkenyl groups per molecule, the resulting electrically conductive silicone elastomer composition will not properly cure via a hydrosilylation reaction, making it unsuitable as a die bonding agent.

In preferred embodiments, the silicon-bonded alkenyl groups of component (A) are selected from the group consisting of vinyl, allyl, butenyl, pentenyl, hexenyl, or heptenyl. Vinyl is particularly preferred. The silicon-bonded alkenyl group of component (A) may be located on the molecular terminal, the molecular side chain or both.

In preferred embodiments, any silicon-bonded organic group, other than the silicon-bonded alkenyl groups, in component (A) is selected from the group consisting of alkyl, cycloalkyl, aryl, aralkyl, halogenated alkyl, alkoxy and hydroxyl groups.

Preferred alkyl groups are selected from the group consisting of methyl, ethyl, propyl, butyl, pentyl, hexyl, heptyl, octyl, nonyl, decyl, and octadecyl. Preferred cycloalkyl groups are selected from the group consisting of cyclopentyl or cyclohexyl. Preferred aryl groups are selected from the group consisting of phenyl, tolyl, xylyl, and naphthyl. Preferred aralkyl groups are selected from the group consisting of benzyl, phenethyl, and phenylpropyl. Preferred halogenated alkyl groups are selected from the group consisting of 3-chloropropyl or 3,3,3-trifluoropropyl. Preferred alkoxy groups are selected from the group consisting of methoxy, ethoxy, propoxy, butoxy, methoxymethoxy and ethoxyethoxy group. Particularly preferred groups are methyl and phenyl.

Examples of the molecular structure of component (A) include straight-chain, partially-branched straight-chain, branched, cyclic, and network, with straight-chain being preferred. Moreover, the viscosity of component (b) at 25°C is within a range of 20-200,000 mPa.s because the physical properties obtained, such as flexibility and elongation, are favorable. Also, the handling and workability of the resulting composition are good. A range of 500-20,000 mPa.s at 25°C is particularly preferred.

Examples of component (A) include dimethylsiloxane-methylvinylsiloxane copolymer having both terminals of the molecule terminated with trimethylsiloxy groups, methylvinylpolysiloxane having both terminals of the molecule terminated with trimethylsiloxy groups, dimethylsiloxane-methylvinylsiloxane-methylphenylsiloxane copolymer having both terminals of the molecule terminated with trimethylsiloxy groups, dimethylpolysiloxane having both terminals of the molecule terminated with dimethylvinylsiloxy groups, dimethylsiloxane-methylvinylsiloxane copolymer having both terminals of the molecule terminated with dimethylvinylsiloxy groups, dimethylsiloxane-methylvinylsiloxane-methylphenylsiloxane copolymer having both terminals of the molecule terminated with dimethylvinylsiloxy groups, organopolysiloxane composed of (CH₂=CH) (CH₃)₂SiO_{1/2} and SiO_{4/2} units, organopolysiloxane composed of (CH₃)₃SiO_{1/2}, (CH₂=CH) (CH₃)SiO_{1/2}, and SiO_{4/2} units, organopolysiloxane composed of (CH₃)₃SiO_{1/2}, (CH₂=CH) (CH₃)₂SiO_{1/2}, (CH₃)₂SiO_{2/2}, and SiO_{4/2} units, and mixtures of two or more of these organopolysiloxanes.

Component (B) is a component for curing the electrically conductive silicone elastomer composition, and it is a silicon-bonded hydrogen atom-containing organopolysiloxane which has an average of at least two silicon-bonded hydrogen atoms per molecule. Component (B) also contains silicon-bonded acrylic functional groups having the formula: 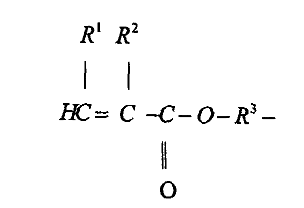 wherein R¹, R², and R³ are described above.

If there are fewer than two of the acrylic functional groups per molecule, when the electrically conductive silicone elastomer composition is irradiated with a high-energy beam, the acrylic functional group free radical reaction will not occur to a sufficient degree. In preferred embodiments, R¹ and R² are selected from the group consisting of alkyl, alkenyl, aryl, and aralkyl. In more preferred embodiments, R¹ and R³ are selected from the group consisting of methyl, ethyl, propyl, vinyl, allyl, phenyl, tolyl, xylyl, benzyl and phenethyl. In preferred embodiments, R³ is selected from the group consisting of methylene, ethylene, propylene, butylene, and pentylene. In more preferred embodiments, R³ is propylene. Preferred acrylic functional groups include 3-acryloxypropyl, 4-acryloxypropyl, and 3-methacryloxypropyl. The more preferred acrylic functional group is 3-methacryloxypropyl.

Component (B) must have an average of at least two silicon-bonded hydrogen atoms per molecule. If there are fewer than two silicon-bonded hydrogen atoms per molecule, the composition will not be sufficiently cured by the hydrosilylation reaction, making it unsuitable as a die bonding agent. Examples of the bonding position for this hydrogen atom are the molecule terminal or the molecular side chains. Moreover, examples of other groups which bond to the silicon atoms in component (B) include alkyl groups such as methyl, ethyl, propyl, butyl, pentyl, hexyl, heptyl, octyl, nonyl, decyl, or octadecyl; cycloalkyl groups such as cyclopentyl group or cyclohexyl; aryl groups such as phenyl, tolyl, xylyl, and naphthyl; aralkyl groups such as benzyl, phenethyl, and phenylpropyl; halogenated alkyl groups such as 3-chloropropyl group or 3,3,3-trifluoropropyl; alkoxy groups such as methoxy, ethoxy, propoxy, butoxy, methoxymethoxy, and ethoxyethoxy; and hydroxyl groups, with a methyl or phenyl group preferred. Moreover, it is necessary for component (B) to have an average of at least two silicon-bonded acrylic groups per molecule.

Examples of the molecular structure of component (B) are straight-chain, partially-branched straight-chain, branched-chain, cyclic, and network. The viscosity of component (B) at 25°C is in the range of 1-50,000 mPa.s; so the resulting composition is storage stable and its handling or workability properties are favorable. A viscosity range of 5-1,000 mPa.s is particularly preferred.

Component (B) is preferably selected from the group consisting of methylhydrogenpolylsiloxane having both molecule terminals terminated with 3-methacryloxypropyl dimethoxysiloxy groups; dimethylsiloxane-methylhydrogensiloxane copolymer having both terminals terminated with 3-methacryloxypropyl dimethoxysiloxy groups; methylhydrogenpolylsiloxane having both terminals capped with 3-methacryloxypropyl diethoxysiloxy groups; dimethylsiloxane-methylhydrogensiloxane copolymer having both molecule terminals terminated with 3-methacryloxypropyl diethoxysiloxy groups; methylhydrogensiloxane-methyl(trimethoxysilylethyl)siloxane-methyl(3-methacryloxypropyl)siloxane copolymer having both molecular terminals capped with trimethylsiloxy groups, dimethylsiloxane-methylhydrogensiloxane-methyl(trimethoxysilylethyl)siloxane-methyl(3-methacryloxypropyl)siloxane copolymer having both terminals terminated with trimethylsiloxy groups; methylhydrogenpolylsiloxane having both molecule terminals terminated with 3-acryloxypropyl dimethoxysiloxy groups; dimethylsiloxane-methylhydrogensiloxane copolymer having both molecule terminals capped with 3-acryloxypropyl dimethoxysiloxy groups; methylhydrogenpolylsiloxane having both molecular terminals terminated with 3-acryloxypropyl diethoxysiloxy groups; dimethylsiloxane-methylhydrogensiloxane copolymer having both molecule terminals terminated with 3-acryloxypropyl diethoxysiloxy groups, methylhydrogensiloxane-methyl(trimethoxysilylethyl)siloxane-methyl(3-acryloxypropyl)siloxane copolymer having both terminals terminated with trimethylsiloxy groups; dimethylsiloxane-methylhydrogensiloxane-methyl(trimethoxysilylethyl)siloxane-methyl(3-acryloxypropyl)siloxane copolymer having both molecule terminals terminated with trimethylsiloxy groups, and mixtures of two or more of these organopolysiloxanes.

An example for manufacturing a silicon-bonded hydrogen atom-containing organopolysiloxane, having an average of at least two silicon-bonded hydrogen atoms per molecule and an average of at least two silicon-bonded acrylic functional groups per molecule, is a method in which an organopolysiloxane, having an average of at least two silicon-bonded hydrogen atoms per molecule and an average of at least two silicon-bonded hydroxyl groups per molecule, and an organic silicon compound having silicon-bonded acrylic functional groups and a silicon-bonded alkoxy group are subjected to a condensation reaction. Examples of such an organopolysiloxane, having an average of at least two silicon-bonded hydrogen atoms per molecule, and an average of at least two silicon-bonded hydroxy groups per molecule include methylhydrogenpolylsiloxane having both molecule terminals terminated with silanol groups, or dimethylsiloxane-methylhydrogensiloxane copolymer having both molecule terminals capped with silanol groups.

Moreover, examples of organic silicon compounds having the aforementioned silicon-bonded acrylic functional group and a silicon-bonded alkoxy group include 3-acryloxypropyl trimethoxysilane: 3-acryloxypropyl dimethylmethoxysilane: 3-acryloxymethylbis(trimethylsiloxy)silane: 3-methacryloxypropenyl trimethoxysilane: 3-methacryloxypropyl dimethylethoxysilane: 3-methacryloxypropyl methyldiethoxysilane: and 3-methacryloxypropyl tris(methoxyethoxy)silane. In the condensation reaction, a commonly-known condensation reaction catalyst may also be used.

Another example is a method in which an organic compound, having an alkenyl group and an acrylic functional group, is subjected to a hydrosilylation reaction with an organopolysiloxane having at least three silicon-bonded hydrogen atoms per molecule in the presence of a platinum-type catalyst. Examples of such organic compounds include allyl methacrylate or 3-methacryloxypropyl dimethyl(vinyldimethylsiloxy)silane. Examples of platinum-type catalysts used in this hydrosilylation reaction are the same catalysts as those specified for component (D) below.

The amount of component (B) in the claimed composition is an amount such that the silicon-bonded hydrogen atoms in component (B) are present in the amount of 0.5-20 moles per mole of silicon-bonded alkenyl group in component (A). If the amount of silicon-bonded hydrogen atoms in component (B)is less than 0.5 moles per mole of the silicon-bonded alkenyl group in component (A), the resulting silicone elastomer compositions will not cure properly and will be unsuitable as a die bonding agent. If the amount of silicon-bonded hydrogen atoms in component (B) is greater than 20 moles per mole of silicon-bonded alkenyl group in component (A), the resulting composition will form bubbles during cure.

Component (C) is an electrically conductive filler for imparting electrical conductivity to our conductive silicone elastomer that is obtained by curing our curable composition. Examples of component (C) include metal such as gold, silver, nickel, and copper; plated substrates in which metals such as gold, silver, nickel, and copper are vapor-deposited on the surface of such substrates as ceramics, glass, quartz, and organic resins. In our electrically conductive silicone elastomer composition, to obtain a volume resistivity which is 0.1 Ωocm or less, component (C) is preferably gold or silver, with silver being preferred for practical use. Examples of the shapes of these metals or plated substrates are spherical, flake, and flake-branch. The flake or flake-branch is particularly preferred. A mixture of flake or flake-branch silver is more particularly preferred. In this latter case, the weight ratio of the flake silver to the flake-branch silver is preferably 80:20 to 20:80. Finally, the average particle diameter of these metals or plated substrates should preferably be 1-10 µm.

The amount of component (C) in our composition is 50-2,000 parts by weight with respect to 100 parts by weight of component (A), with 300-1,000 parts by weight being preferred. If the amount of component (C) is less than 50 parts by weight with respect to 100 parts by weight of component (A), it is not possible to impart sufficient electrical conductivity to the product silicone elastomer. If it exceeds 2000 parts by weight, the handling and workability of the resultant composition will deteriorate.

Component (D) is a photosensitizer for promoting the free radical reaction of the acrylic functional groups in component (B) when our curable composition is irradiated with a high-energy beam. Examples of component (D) include acetophenones such as acetophenone, dichloroacetophenone, trichloroacetophenone, tert-butyltrichloroacetophenone, 2,2-diethoxyacetophenone, and p-dimethylaminoacetophenone or derivatives thereof; benzoins such as benzoinmethyl ether, benzoinethyl ether, benzoinisobutyl ether, and benzoinbutyl ether or derivatives thereof; benzophenones such as benzophenone, 2-chlorobenzophenone, p,p'-dichlorobenzophenone, and p,p'-bisdiethylaminobenzophenone or derivatives thereof; p-dimethylaminopropiophenone; hydroxyisobutylphenone; Michler's ketone; benzyl; benzyldimethyl ketal; tetramethyl thiuram monosulfide; thioxanthone; 2-chlorothioxanthone; 2-methylthioxanthone; azoisobutyronitrile; benzoisoperoxide; di-tert-butylperoxide; 1-hydroxychlorohexylphenyl ketone; 2-hydroxy-2-methyl-1-phenylpropan-1-one; 1-(4-isopropylphenyl)-2-hydroxy-2-methylpropan-1-one; methylbenzoylformate; diphenylsulfide; anthracene; 1-chloroanthraquinone; diphenyldisulfide; diacetyl; hexachlorobutadiene; pentachlorobutadiene; octachlorobutadiene; and 1-chloromethylnaphthalene; or mixtures of two or more kinds of these photosensitizers. Acetophenone, benzoin, benzophenone, and their derivatives are preferred.

The amount of component (D) in our composition is 1-20 parts by weight with respect to 100 parts by weight of component (A), with 5-15 parts by weight preferred. If the amount of component (D) is less than 1 part by weight with respect to 100 parts by weight of component (A), the free radical reaction of the acrylic functional groups is difficult to produce, making it impossible to achieve the purpose of this invention. If the amount of component (D) exceeds 20 parts by weight, the resulting composition will exhibit poor storage stability, poor handling and decreased workability properties.

Component (E) is a platinum-type catalyst for promoting the hydrosilylation reaction of the claimed composition of this invention. Examples of component (E) include platinum black, platinum activated charcoal, platinum-carrying silica, chloroplatinic acid, alcohol solutions of chloroplatinic acid, complexes of platinum and olefins, complexes of platinum and vinylsiloxane, and catalysts composed of thermoplastic resins containing these platinum-type catalysts. Examples of these thermoplastic resins include silicone, polycarbonate, acrylic, nylon, and polyester. Moreover, the softening point of this thermoplastic resin is preferably 5-20°C, and its particle diameter is preferably 0.01-10 µm.

The amount of component (E) in our composition is an amount sufficient to achieve cure of said composition. The amount of component (E) provides an amount of platinum metal in our composition ranging from 0.1-1,000 ppm, with 0.5-500 ppm being preferred.

Adhesion-promoting agents may also be added with these electrically conductive silicone elastomer compositions as optional components. They include alkoxysilanes such as tetramethoxysilane, tetraethoxysilane, dimethyldimethoxysilane, methylphenyldiethoxysilane, phenyltrimethoxysilane, methyltrimethoxysilane, methyltriethoxysilane, vinyltrimethoxysilane, allyltrimethoxysilane, allyltriethoxysilane, 3-glycidoxypropyltrimethoxysilane, and 3-methacryloxypropyltrimethoxysilane; or organopolysiloxanes having the following formulas: 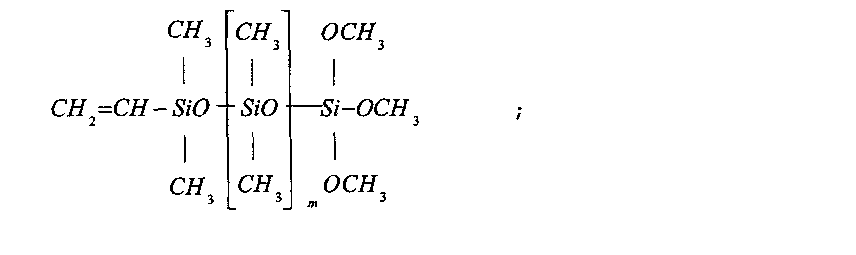 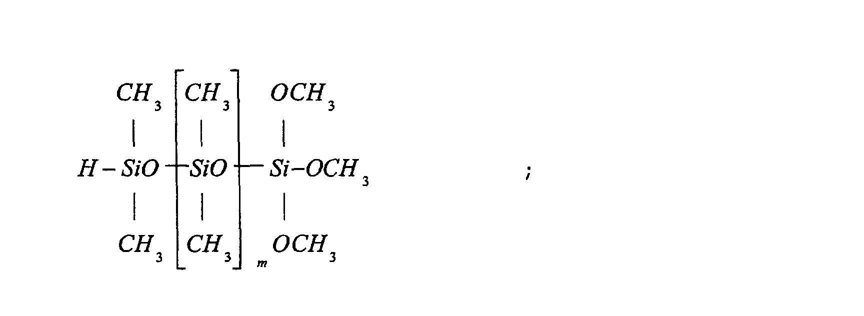 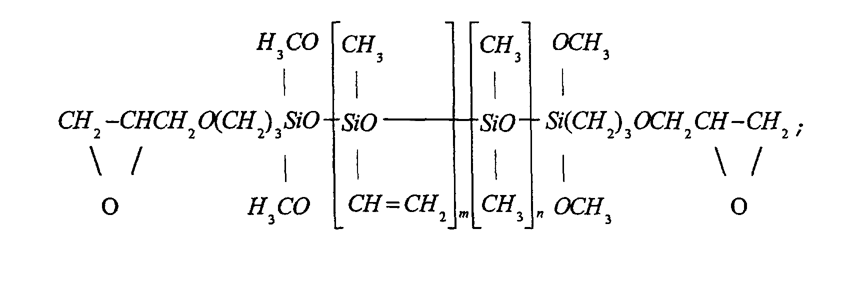 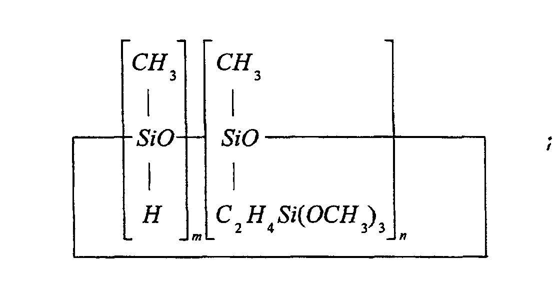 and 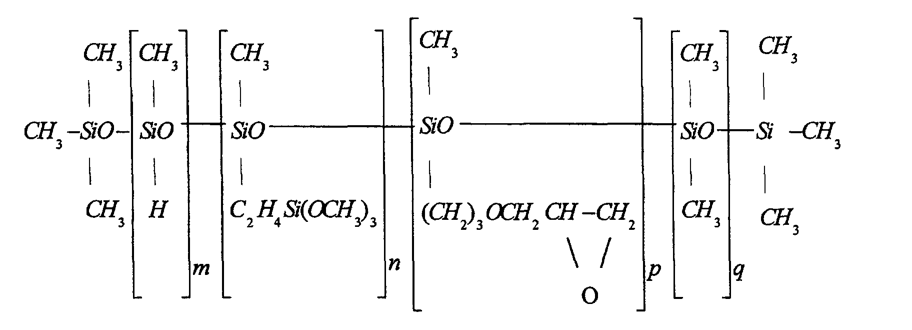 wherein m, and p are positive number, and q is 0 or a positive numbers. Such adhesion-promoting agents are present in an amount ranging from 0.01-20 parts by weight with respect to 100 parts by weight of component (A). A range from 0.1-5 parts by weight is particularly preferred.

Moreover, other optional components may be mixed in with electrically conductive silicone elastomer compositions including acetylene compounds such as 3-methyl-1-butyn-3-ol; and 3,5-dimethyl-1-hexyn-3-ol; 3-phenyl-1-butyn-3-ol; enyne compounds such as 3-methyl-3-penten-1-yne or 3,5-dimethyl-3-hexen-1-yne; cycloalkenylsiloxanes such as 1,3,5,7-tetramethyl-1,3,5,7-tetravinylcyclotetrasiloxane or 1,3,5,7-tetramethyl-1,3,5,7-tetrahexenylcyclotetrasiloxane; triazole compounds such as benzotriazole; and addition reaction inhibitors such as phosphine compounds, mercaptan compounds, and hydrazine compounds. The amount of these addition reaction inhibitors in the composition differs depending on the curing conditions. Generally speaking, however, this inhibitor is provided in an amount of 10-1,000 ppm by weight with respect to the electrically conductive silicone elastomer composition.

Furthermore, examples of other components which may be optionally mixed in with our electrically conductive silicone elastomer compositions include inorganic fillers, such as fumed silica, wet silica, quartz, calcium carbonate, titanium dioxide, diatomaceous earth, aluminum dioxide, aluminum hydroxide, zinc oxide, and zinc carbonate; or hydrophobic inorganic fillers, such as the above fillers which have been surface-treated with organoalkoxysilanes such as methyltrimethoxysilane; organohalosilanes such as trimethylchlorosilane; organosilanes such as hexamethyldisilane; or siloxane oligomers such as dimethylsiloxane oligomer; methylphenylsiloxane oligomer, and methylvinylsiloxane oligomer, all having both molecular terminals capped with hydroxyl groups.

Finally, organic solvents such as toluene, xylene, acetone, methylethyl ketone, methylisobutyl ketone, hexane, and heptane; non-cross-linking organopolysiloxanes such as polydimethylsiloxane and polymethylphenylsiloxane both having their molecular terminals terminated with trimethylsiloxy groups; flame retardants; heat-resisting agents; plasticizers; thixotropic agents; and antifungal agents.

Examples of high-energy beams used to induce the free radical reaction of our electrically conductive silicone elastomer compositions include visible light, ultraviolet rays, x-rays, and electron beams, with ultraviolet rays being preferred for practical use. In methods for irradiation using ultraviolet rays, light sources such as hydrogen discharge tubes, high-pressure mercury lamps, medium-pressure mercury lamps, low-pressure mercury lamps, metal halide lamps, xenon lamps, chemical lamps, and carbon arc lamps are preferably employed. The wavelength of these ultraviolet rays are preferably in the range of 250-400 nm. Concerning conditions of irradiation with ultraviolet rays, the electrically conductive silicone elastomer composition can be irradiated under refrigeration, at room temperature, or under heating. And, the irradiation may occur in an inert gas atmosphere, such as nitrogen or argon; in air; or in a vacuum. The total irradiation dose of ultraviolet rays is 15 J/cm² or less at a wavelength of 250-400 nm. An irradiation range of 1-8 J/cm² is preferred. The time of this irradiation is preferably immediately after application of our electrically conductive silicone elastomer composition to a substrate. The fact that our silicone elastomer composition has undergone a suitable acrylic functional group free radical reaction due to high-energy beam irradiation is confirmed by an increase in viscosity or film formation, on the surface of the resulting cured elastomer composition, but it is not necessarily accompanied by changes in external appearance.

The temperature at which our electrically conductive silicone elastomer composition is cured by a hydrosilylation reaction is in the range of 50-300°C. A range of 100-250°C is preferred. Concerning the method for heating our electrically conductive silicone elastomer composition, the use of heating devices such as an infrared irradiation device, hot-air circulation oven, or hot plate is preferred.

Concerning the hardness of our electrically conductive silicone elastomer obtained herein, its JIS A hardness, as specified by JIS K 6301, is 20 or above, with a figure of 30-95 being preferred.

Our electrically conductive silicone elastomer composition may be used as a die bonding agent for bonding semiconductor chips to substrates, packages, and so forth. Once the semiconductor chip has been mounted on a substrate by means of our curable elastomer, and it has been irradiated with a high-energy beam which causes an acrylic functional group free radical reaction, it is possible to inhibit outgassing of low molecular-weight silicone oil from said composition before and during curing by the hydrosilylation reaction. The semiconductor chip, substrate, package, and lead frame are therefore not contaminated by low molecular-weight silicone oil. This fact offers the advantage of eliminating or at least decreasing defects in wire bondability to semiconductor chips, lead frames, etc. Furthermore, adhesion defects between semiconductor chips, substrates, packages, or lead frames and the sealing resin are also minimized or eliminated. Unexpectedly, when these components have been adhered using the composition of the present invention, and are then soldered or a conformal coating is applied over them, soldering defects, crawling of the coating, etc., do not occur. Therefore, there is the surprising advantage that by using our electrically conductive silicone elastomer composition as a die bonding agent, it is possible to manufacture semiconductor devices having outstanding reliability, such as moisture resistance, with favorable yields.

Next, the method for manufacturing semiconductor devices of the present invention, and the obtained semiconductor devices obtained by this method will be explained in detail.

Fig. 1 is a sectional diagram of a semiconductor device of the patent invention which is used in the examples.

Fig. 2 is a sectional diagram of another semiconductor device according to the present invention demonstrated in the examples.

### Explanation of Symbols

1. Semiconductor chip
2. Tab
3. Electrically conductive silicone elastomer
4. Aluminum bonding pad
5. Copper lead frame
6. Gold bonding wire
7. Epoxy sealing resin
8. Ceramic circuit board
9. Copper circuit wiring
10. Electrical components such as condensers or resistors.

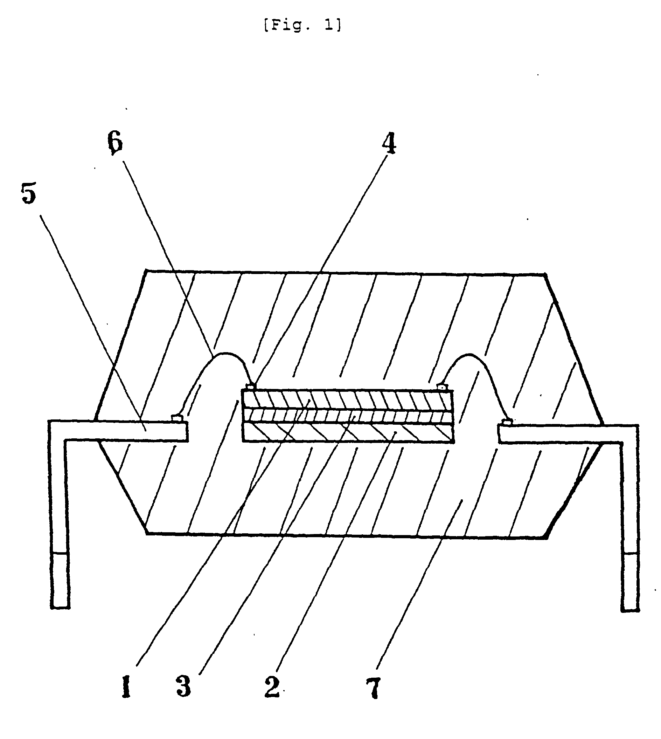

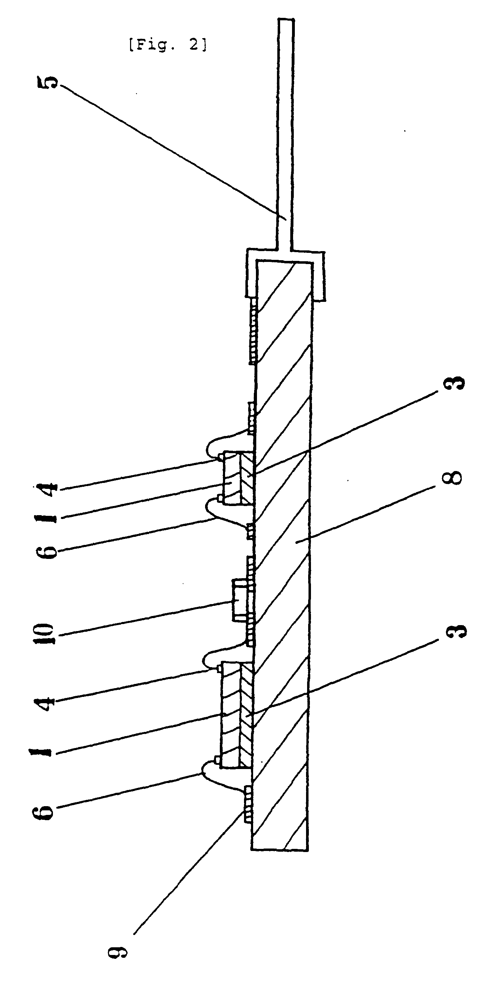

Examples of semiconductor devices manufactured by the method of this invention include diodes, transistors, thyristors, monolithic ICs, hybrid ICs, LSIs, and VLSIs. Moreover, examples of semiconductor chips in semiconductor devices include diodes, transistors, thyristors, monolithic ICs, and hybrid Ics. As shown in Fig. 1, a semiconductor device obtained by our manufacturing method is characterized in that a semiconductor chip 1 and a tab 2 are adhered by means of an electrically conductive silicone elastomer composition which has been cured to form an electrically conductive silicone elastomer. (A tab is a substrate upon which a semiconductor chip may be mounted). Examples of raw materials of this tab 2 include copper or iron alloys. Further, as shown in Fig. 2, in another semiconductor device obtained by our manufacturing method, a circuit board 8 is composed of raw materials, such as ceramics or glass, and is used as the substrate for mounting the semiconductor chip 1. Circuit wiring 9 is formed on the surface of circuit board 8 by means of metals such as gold, silver, and copper, and electrical components 10 such as capacitors, resistors, and coils may also be mounted on the surface of this circuit board 8.

After a semiconductor chip 1 is mounted on a tab 2 or a ceramic circuit board 8, by means of our electrically conductive silicone elastomer composition, a free radical reaction of the acrylic functional group of said composition is induced, by irradiating this electrically conductive silicone elastomer composition with a high-energy beam. The ultraviolet irradiation is preferably conducted immediately after mounting of the semiconductor chip.

The electrically conductive silicone elastomer composition was next cured by means of a hydrosilylation reaction, and the semiconductor chip 1 is caused to adhere to the tab 2 or the ceramic circuit board 8.

After the electrically conductive silicone elastomer 3 was formed in this manner, wire bonding of the aluminum-bonding pad 4 installed at the upper edge of the semiconductor chip 1 and the metal lead frame 5 or copper circuit wiring 9 was performed by means of gold bonding wire 6. In addition to gold, examples of this bonding wire include copper and aluminum. Examples of wire-bonding methods include the thermocompression bonding method, the ultrasonic bonding method, and the ultrasonic thermocompression bonding method. Then, silicone elastomer or silicone gel was formed on the surface of this semiconductor chip 1 to protect it. Moreover, if needed, the semiconductor device of the present invention may be formed by resin sealing of the semiconductor chip 1 by means of sealing resin 7. Examples of this sealing resin 7 are epoxy resin, phenol resin, and polyphenylene sulfide resin.

### EXAMPLES

Our electrically conductive silicone elastomer composition, our method for manufacturing a semiconductor device, and the resulting semiconductor device are now shown by means of practical examples. The viscosity values in the examples were measured at 25°C. Furthermore, evaluations of the hardness and volume resistivity, the manufacturing method, the wire bondability, the moisture resistance, , and the adhesion properties of the sealing resin were determined as follows.

Hardness of the electrically conductive silicone elastomer: was determined as follows. After ultraviolet irradiation of composition using a conveyor-type ultraviolet irradiation device (manufactured by Ushio Denki TM K.K.; UVC-2533/1MNLC3-AA08) by means of a 160 W/cm high-pressure mercury lamp to a total irradiation dosage of 5 J/cm², it was heated for 30 minutes at 150°C to form an electrically conductive elastomer. The hardness of said conductive silicone elastomer was measured using the JIS A hardness meter specified in JIS K 6301.

Volume resistivity of the electrically conductive silicone elastomer was tested as follows. An electrically conductive silicone elastomer sheet 1 mm in thickness was formed as above. The volume resistivity of this sheet was measured using a resistivity measurement device (Model K-705RL manufactured by Kyowa TM Riken Ltd.).

The manufacturing methods of the semiconductor device and wire bondability were evaluated as follows. The semiconductor device shown in Fig. 1 was prepared. This semiconductor device had 144 leads in its lead frame, and the size of the semiconductor chip was 10 mm x 10 mm. This semiconductor chip 1 was mounted on the tab 2 by means of the electrically conductive silicone elastomer composition, and irradiated with ultraviolet rays using the conveyor device mentioned above. The surface of the electrically conductive silicone elastomer composition, extruded on the periphery of the chip, was thereby caused to undergo an acrylic functional group free radical reaction. The composition was heated for 10 minutes at 150°C to form electrically conductive silicone elastomer 3. Wire bonding of the aluminum bonding pad 4, installed on the upper edge of the semiconductor chip 1, and the gold lead frame 5, was then conducted using gold bonding wire 6. Thus, a semiconductor device was then formed. The wire bonding was then performed using the ultrasonic thermocompression bonding method (bonding temperature: 160-250°C, load: 30-100 mg/unit). 20 of these semiconductor devices were prepared. Next, neck formation between the gold bonding wire 6, and the bonding pad 4 or copper lead frame 5, was observed under a microscope. At this time, by stretching the gold bonding wire 6, the bonding status of this wire was observed. The wire bondability was expressed as the rate of bonding defects of the bonding wire 6.

Moisture resistance of these semiconductor devices was tested as follows. Semiconductor devices were prepared by resin sealing, using epoxy resin, of a semiconductor chip to which bonding wire 6 was favorably bonded. 20 of these semiconductor devices were heated for specified periods in saturated water vapor at 121°C and 202.6 kPa (2 atmospheres) of pressure. After heating, an electric current was applied to the semiconductors, and the leak current between the copper lead frame 4 was measured. Thereafter, moisture resistance of the semiconductors was expressed as the rate of increase in leak current and defective semiconductor devices in which conduction was defective.

Adhesion of semiconductor chips and sealing resin were also determined herein. After 20 semiconductor devices which had been resin-sealed using epoxy resin were left standing for 168 hours under conditions of 85°C and 85% RH, they were heated using an IR reflow at 245°C. After heating, the semiconductor devices were observed using an ultrasonic microscope, and separation occurring between the semiconductor chip 1 and the epoxy resin sealing material was observed. The rate of occurrence of semiconductor devices showing peeling was determined.

### Example 1

100 parts by weight of an organopolysiloxane mixture, composed of 23.5% by weight of a dimethylpolysiloxane having both molecule terminals terminated with 3-methacryloxypropyl dimethoxysiloxy groups and having a viscosity of 15,000 mPa.s and silicone resin composed of (CH₃)₃SiO_{1/2}, CH₂=C(CH₃)COOC₃H₆(CH₃O)₂SiO_{1/2}, and SiO₂ units, and 76.5% by weight of a mixture of dimethylsiloxaneomethylvinylsiloxane copolymer having both terminals capped with dimethylvinylsiloxy groups and silicone resin composed of (CH₃)₃SiO_{1/2}, (CH₂=CH) (CH₃)₂SiO_{1/2}, and SiO₂ units (vinyl group content = 0.9% by weight), 16 parts by weight of methylhydrogensiloxaneodimethylsiloxane copolymer having both molecular terminals terminated with hydrogensiloxy groups and having a viscosity of 30 mPa.s (amount of silicon-bonded hydrogen atoms = 0.75% by weight), 17 parts by weight of organopolysiloxane having the following formula: 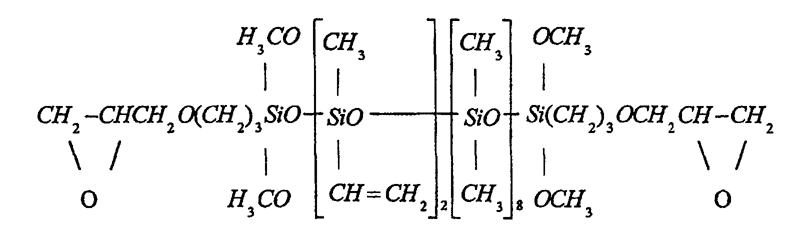 510 parts by weight of flake-type silver having an average particle diameter of 7 µm, 10 parts by weight of benzophenone as a photosensitizer, 7 parts by weight of hydrophobic fumed silica which was surface-treated with hexamethyldisilazane and having a specific surface area of 200 m²/g, a 1,1,3,3-tetramethyl-1,3-divinyldisiloxane complex of platinum (in an amount such that the platinum metal content in the composition was 15 ppm by weight), and 3-phenyl-1,butyn-3-ol (in an amount such that the content in the composition was 350 ppm by weight) were uniformly mixed to prepare an electrically conductive silicone elastomer composition. Semiconductor devices prepared using this electrically conductive silicone elastomer composition have their results in Table 1.

### Example 2

100 parts by weight of an organopolysiloxane mixture composed of 22.5% by weight of a composition of dimethylpolysiloxane having both molecular terminals terminated with 3-methacryloxypropyl dimethoxysiloxy groups and having a viscosity of 15,000 mPa.s and silicone resin composed of (CH₃)₃SiO_{1/2}, CH₂=C(CH₃)COOC₃H₆(CH₃O)₂SiO_{1/2}, and SiO₂ units, and 77.5% by weight of a mixture of dimethylsiloxaneomethylvinylsiloxane copolymer having both molecular terminals capped with dimethylvinylsiloxy groups and silicone resin composed of (CH₃)₃SiO_{1/2}, (CH₂=CH) (CH₃)₂SiO_{1/2}, and SiO₂ units (vinyl group content = 0.9% by weight), 16 parts by-weight of methylhydrogensiloxaneodimethylsiloxane copolymer having both molecular terminals terminated with hydrogensiloxy groups and having a viscosity of 30 mPa.s (amount of silicon-bonded hydrogen atoms= 0.75% by weight), 17 parts by weight of organopolysiloxane having the following formula: 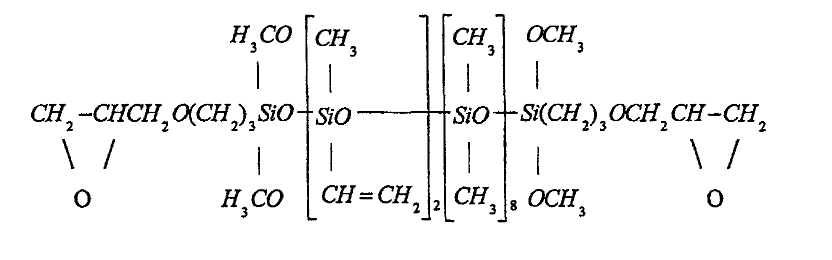 510 parts by weight of flake-type silver having an average particle diameter of 5 µm, 9 parts by weight of 2-hydroxy-2-methyl-1-phenylpropan-1-one as a photosensitizer, 3 parts by weight of hydrophobic fumed silica which had been surface-treated with hexamethyldisilazane and having a specific surface area of 200 m²/g, a 1,1,3,3-tetramethyl-1,3-divinyldisiloxane complex of platinum (in an amount such that the platinum metal content in the composition was 15 ppm by weight), and 3-phenyl-1,butyn-3-ol (in an amount such that the content in the composition was 350 ppm by weight) were uniformly mixed to prepare an electrically conductive silicone elastomer composition. Semiconductor devices prepared using this electrically conductive silicone elastomer composition have their evaluations given in Table 1.

### Example 3

100 parts by weight of organopolysiloxane composed of (CH₃)₃SiO_{1/2}, CH₂=C(CH₃)COOC₃H₆(CH₃O)₂SiO_{1/2}, (CH₂=CH) (CH₃)₂SiO_{1/2}, and SiO₂ units (vinyl group content = 1.0% by weight), 18 parts by weight of methylhydrogensiloxaneodimethylvinylsiloxane copolymer having both molecular terminals capped with dimethylhydrogensiloxy groups having a viscosity of 30 mPa.s (amount of hydrogen atoms bound to silicon atoms = 0.75% by weight), 17 parts by weight of organopolysiloxane having the following formula: 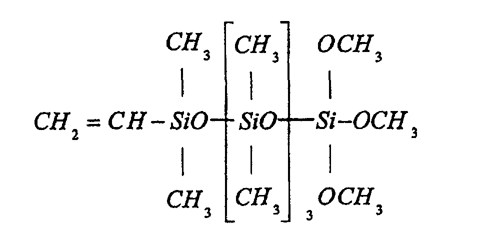 650 parts by weight of flake-type silver having an average particle diameter of 5 µm, 9 parts by weight of a mixture of benzophenone and 2-hydroxy-2-methyl-1-phenylpropan-1-one in a weight ratio of 1 : 1 as a photosensitizer, 3 parts by weight of hydrophobic fumed silica which had been surface-treated with hexamethyldisilazane and having a specific surface area of 200 m²/g, a 1,1,3,3-tetramethyl-1,3-divinyldisiloxane complex of platinum (in an amount such that the platinum metal content in the composition was 15 ppm by weight), and 3-phenyl-1,butyn-3-ol (in an amount such that the content in the composition was 350 ppm by weight) were uniformly mixed to prepare an electrically conductive silicone elastomer composition. Semiconductor devices were prepared using this electrically conductive silicone elastomer composition have their results listed in Table 1.

### Comparison Example 1

100 parts by weight of dimethylpolysiloxane having both molecular terminals terminated with dimethylhyvinylsiloxy groups having a viscosity of 2,000 mPa.s (vinyl group content = 0.2% by weight), 2.5 parts by weight of methylhydrogenpolylsiloxane having both molecule terminals terminated with trimethylsiloxy groups having a viscosity of 20 mPa.s (amount of hydrogen atoms bound to silicon atoms = 1.5% by weight), 8 parts by weight of organopolysiloxane having the following formula: 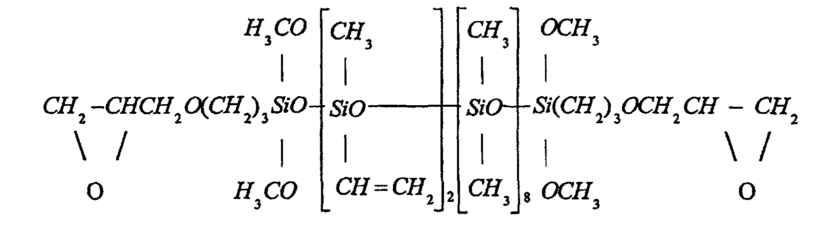 480 parts by weight of flake-type silver having an average particle diameter of 5 µm, 9 parts by weight of hydrophobic fumed silica which had been surface-treated with hexamethyldisilazane and having a specific surface area of 200 m²/g, a 1,1,3,3-tetramethyl-1,3-divinyldisiloxane complex of platinum (in an amount such that the platinum metal content in the composition was 15 ppm by weight), and 3-phenyl-1,butyn-3-ol (in an amount such that the content in the composition was 350 ppm by weight) were uniformly mixed to prepare an electrically conductive silicone elastomer composition. Semiconductor devices prepared using this electrically composition are also evaluated in Table 1.

### Comparison Example 2

Using the electrically conductive composition prepared in Comparison Example 1, semiconductor devices were prepared in the same manner as in Comparison Example 1, except ultraviolet irradiation was not carried out. The results of evaluation thereof are reported in Table 1.

### Comparison Example 3

Using the electrically conductive silicone elastomer composition prepared in Example 1, semiconductor devices were prepared in the same manner as Example 1, except ultraviolet irradiation was not carried out. The results of evaluation thereof are in Table 1.

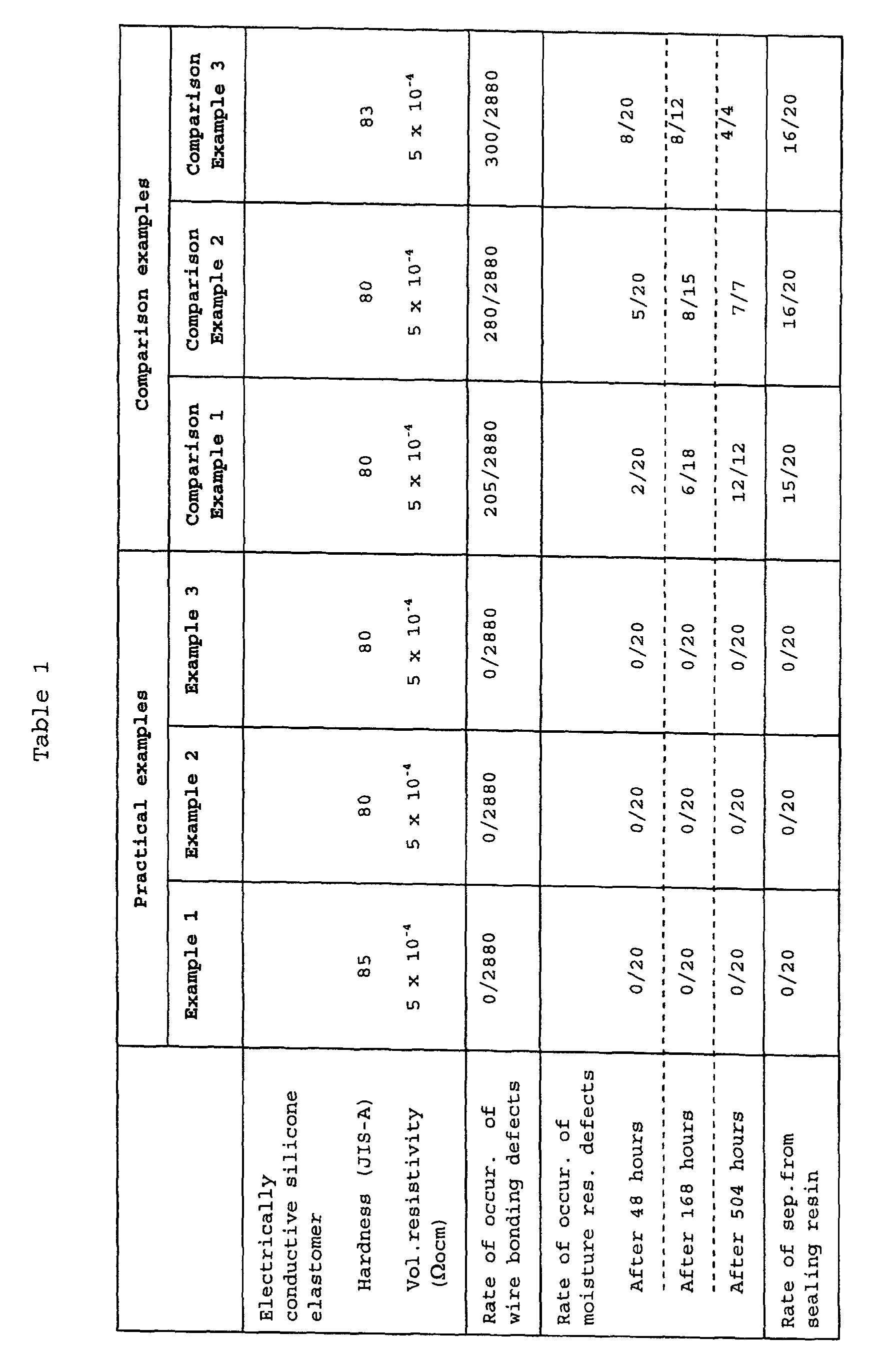

## Claims

1. An electrically conductive silicone elastomer composition, comprising
(A) 100 parts by weight of an alkenyl group-containing organopolysiloxane having an average of at least two silicon-bonded alkenyl groups per molecule;
(B) a silicon-bonded hydrogen atom-containing organopolysiloxane having an average of at least two silicon-bonded hydrogen atoms per molecule and an average of at least two silicon-bonded acrylic groups per molecule having the formula 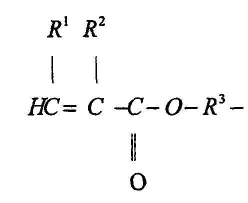 wherein R¹ and R² are each a hydrogen atom or a monovalent hydrocarbon group, and R³ is a divalent hydrocarbon group having 1-10 carbon atoms; in an amount sufficient to provide 0.5-20 moles of silicon-bonded hydrogen atoms in component (B) per mole of silicon-bonded alkenyl group in component (A);
(C) 50-2,000 parts by weight of an electrically conductive filler;
(D) 0.1-20 parts by weight of a photosensitizer; and
(E) a platinum-type catalyst, in an amount sufficient to curs the electrically conductive silicone elastomer composition.

2. A method for manufacturing a semiconductor device, comprising the steps of:
mounting a semiconductor chip on a substrate using the electrically conductive silicone elastomer composition of claim 1;
irradiating said composition with a high-energy beam to induce an acrylic functional group free radical reaction; and then
allowing the composition to cure via a hydrosilylation reaction.

## Patentansprüche

1. Elektrisch leitfähige Siliconelastomerzusammensetzung, enthaltend:
(A) 100 Gewichtsteile eines alkenylgruppenhaltigen Organopotysiloxans mit durchschnittlich mindestens zwei siliciumgebundenen Alkenylgruppen pro Molekül;
(B) ein Organopolysiloxan mit siliciumgebundenen Wasserstoffatomen, das durchschnittlich mindestens zwei siliciumgebundene Wasserstoffatome pro Molekül und durchschnittlich mindestens zwei siliciumgebundene Acrylgruppen pro Molekül mit der Formel 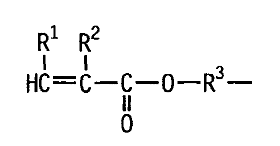 enthält, worin R¹ und R² jeweils ein Wasserstoffatom oder eine monovalente Kohlenwasserstoffgruppe sind und R³ eine divalente Kohlenwasserstoffgruppe mit 1-10 Kohlenstoffatomen ist;
in einer Menge die ausreicht, um 0,5-20 mol siliciumgebundene Wasserstoffatome in Komponente (B) pro mol siliciumgebundene Alkenylgruppe in Komponente (A) bereitzustellen:
(C) 50-2.000 Gewichtsteile eines elektrisch leitfähigen Füllstoffs;
(D) 0,1-20 Gewichtsteile eines Fotosensibilisators und
(E) einen Katalysator des Platintyps in einer Menge, die ausreicht, um die elektrisch leitfähige Siliconelastomerzusammensetzung zu härten.

2. Verfahren zur Herstellung eines Halbleiterbauteils, umfassend die Schritte:
Montieren eines Halbleiterchips auf einem Substrat unter Verwendung der elektrisch leitfähigen Siliconelastomerzusammensetzung nach Anspruch 1;
Bestrahlen dieser Zusammensetzung mit einem hochenergetischen Strahl, um radikalische Reaktion der acrylfunktionellen Gruppen zu induzieren, und dann
Härtenlassen der Zusammensetzung über eine Hydrosilylierungsreaktion.

## Revendications

1. Composition électroconductrice de caoutchouc de silicone comprenant
(A) 100 parties en poids d'un organopolysiloxane contenant des groupes alcényles, ayant une moyenne d'au moins deux groupes alcényles liés à un atome de silicium par molécule ;
(B) un organopolysiloxane contenant des atomes d'hydrogène liés à un atome de silicium ayant une moyenne d'au moins deux atomes d'hydrogène liés à un atome de silicium par molécule et une moyenne d'au moins deux groupes acryliques liés à un atome de silicium par molécule ayant la formule 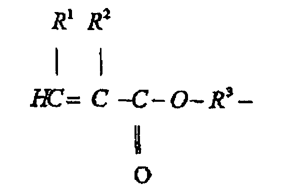 dans laquelle R¹ et R² sont chacun un atome d'hydrogène ou un groupe hydrocarbure monovalent, et R³ est un groupe hydrocarbure divalent possédant 1-10 atomes de carbone ; en quantité suffisante pour fournir 0,5-20 moles d'atomes d'hydrogène liés à un atome de silicium dans le composant (B) par mole de groupe alcényle lié à un atome de silicium dans le composant (A) ;
(C) 50-2 000 parties en poids d'une charge électroconductrice ;
(D) 0,1-20 parties en poids de photosensibilisateur ; et
(E) un catalyseur de type platine, en quantité suffisante pour faire durcir la composition électroconductrice de caoutchouc de silicone.

2. Méthode de fabrication d'un dispositif semiconducteur comprenant les étapes suivantes :
montage d'une puce semi-conductrice sur un substrat en utilisant la composition électroconductrice de caoutchouc de silicone de la revendication 1 ;
irradiation de ladite composition avec un faisceau de haute énergie pour induire une réaction radicalaire des groupes fonctionnels acryliques ; et puis
durcissement de la composition par réaction d'hydrosilylation.
